Europäisches Patentamt

European Patent Office

Office européen des brevets

(19)

(11) Publication number: **0 440 411 A2**

## EUROPEAN PATENT APPLICATION

(12)

(21) Application number: 91300649.0

(22) Date of filing: 29.01.91

(51) Int. Cl.⁵: **H01L 39/12**, H01L 39/24

(30) Priority: 31.01.90 JP 23058/90

(43) Date of publication of application:
07.08.91 Bulletin 91/32

(84) Designated Contracting States:
DE FR GB

(71) Applicant: SHARP KABUSHIKI KAISHA
22-22 Nagaike-cho Abeno-ku
Osaka(JP)

(72) Inventor: Taniguchi, Hiroshi
2-506, Nara high town, 606-76, Sanjo-cho
Nara-shi, Nara(JP)
Inventor: Nojima, Hideo
203, Wakakusa heights, 65-10,
Minaminagai-cho
Nara-shi, Nara(JP)
Inventor: Koba, Masayoshi
1-51-14-5, Shichijonishi-machi
Nara-shi, Nara(JP)

(74) Representative: West, Alan Harry et al
R.G.C. Jenkins & Co. 26 Caxton Street
London SW1H 0RJ(GB)

(54) Oxide superconductor.

(57) In an oxide superconductor having a composition and the crystal structure of $YBa_2Cu_3O_{7-\delta}$, barium is partially substituted by potassium, the potassium atoms supplying conduction electrons. The oxide superconductor is produced by mixing and sintering the constituent oxides in their required proportions, but the step of annealing to increase oxygen content may be omitted.

EP 0 440 411 A2

## OXIDE SUPERCONDUCTOR

The present invention relates to an oxide superconductor.

High temperature oxide superconductors $YBa_2Cu_3O_y$ have critical temperatures $T_c$ above $77°$ K, the boiling point of liquid nitrogen, and are expected to find wide use in electronic materials. However, it is to be noted that the characteristics of these oxide superconductors depend on their compositional ratio of oxygen. That is, if y is about 7.0 in the above formula, then $T_c$ is about $90°$ K, while if y is reduced to around 6.5, then $T_c$ is about $60°$ K. If y is further reduced to about 6.0, then the oxide superconductor exhibits no superconducting properties.

The reason why the characteristics of these yttrium oxide superconductors vary with the compositional ratio of oxygen is that the conduction holes which serve as carriers of the superconducting current are supplied from oxygen atoms located on the b-axis at the Cu(1) sites forming the Cu-O chains in the oxide superconductor. Accordingly, in order to obtain oxide superconductors having high $T_c$ values, the production processes for such oxide superconductors include a heat treatment in air or an oxidizing atmosphere to increasing the compositional ratio of oxygen. However, the heat treatment complicates the production process and lengthens the production time. Further, it then becomes very difficult to form a film of the oxide superconductor on a semiconductor substrate or the like. Thus, the manufacture of complex devices which include at least one semiconductor and superconductor, becomes difficult.

The present invention seeks to provide an oxide superconductor which does not require the oxidizing heat treatment step in order to increase its compositional ratio of oxygen.

An oxide superconductor according to the present invention has a composition $YBa_{2(1-x)}K_{2x}Cu_3O_{7-\delta}$ in which x has a value between about 0.01 and about 0.1, and $\delta$ has a value between about one and zero.

It is an advantage of an oxide superconductor according to the invention that the production process and the production time can be shortened by omitting the heat treatment step for controlling the compositional ratio of oxygen.

It is another advantage of an oxide superconductor according to the invention that various complex devices can be produced by combining it with materials such as semiconductors which are apt to deteriorate in an oxidizing atmosphere.

The invention is described below in greater detail by way of example only with reference to the accompanying drawings, in which

Figure 1 is a graph of the temperature dependence of the electrical resistance of a superconductor of the invention;

Figure 2(a) is a diagram of the crystal structure of $YBa_2Cu_3O_y$, while Figure 2(b) indicates the crystal axes of the structure shown in Figure 2-(a);

Figure 3 is an X-ray powder diffraction pattern of a superconductor of the invention; and

Figure 4 shows the results of thermal analysis by differential scanning calorimetry in a heating process, of a superconductor of the invention.

An oxide superconductor according to the invention is produced by conventional solid state reaction with the use of powder materials of $Y_2O_3$, $BaCO_3$, $K_2CO_3$ and CuO. The powder materials are weighed to a compositional ratio $Y(Ba_{0.95}K_{0.05})_2Cu_3$. The powder materials are then mixed, presintered, crushed and mixed again. Next, the mixed powder is pressed to form pellets, and they are sintered at $290°$ C for six hours. As explained above, the prolonged annealing step to increase the compositional ratio of oxygen is omitted, in contrast to the prior art methods for oxide superconductors.

The resulting oxide superconductor pellets exhibit the Meissner effect at liquid nitrogen temperatures.

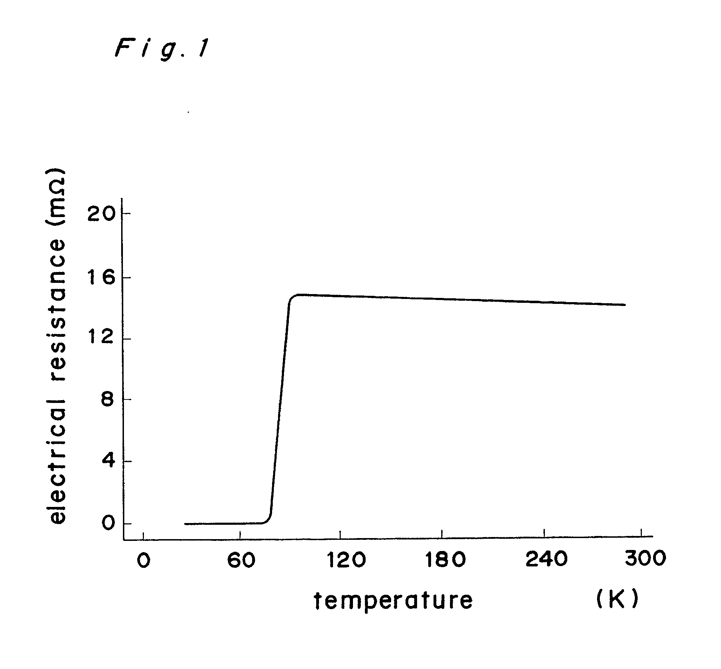

Referring to the drawings, Figure 1 shows the temperature dependence of the electrical resistance of the above oxide superconductor. As shown in Figure 1, the oxide superconductor has an electrical resistance which is almost constant from room temperature down to about $100°$ K, while the electrical resistance decreases rapidly from about $100°$ K ($T_c$ (onset)) and becomes zero at $79°$ K ($T_c$ (zero)).

It is clear from the temperature dependence of the electrical resistance shown in Figure 1, that the characteristic $T_c$ of the oxide superconductor according to the invention is of the same order as that of a prior art oxide superconductor which is produced using the prolonged heat treatment step in order to control the compositional ratio of oxygen.

The oxide superconductor according to the invention will be expected fully to be improved further in superconducting characteristics such as $T_c$. The production process and the production time can be shortened. Further, it is expected that oxide superconductors and especially thin film superconductors according to the invention can find use in various fields of application. Because thin films of oxide superconductor can be produced in vacuo, various electronics devices such as sensor elements, electronic instruments and the like and metallization in integrated circuits can be produced by combining such oxide superconductors with materials such as semiconductors which are easily damaged by heat in an oxidizing atmosphere.

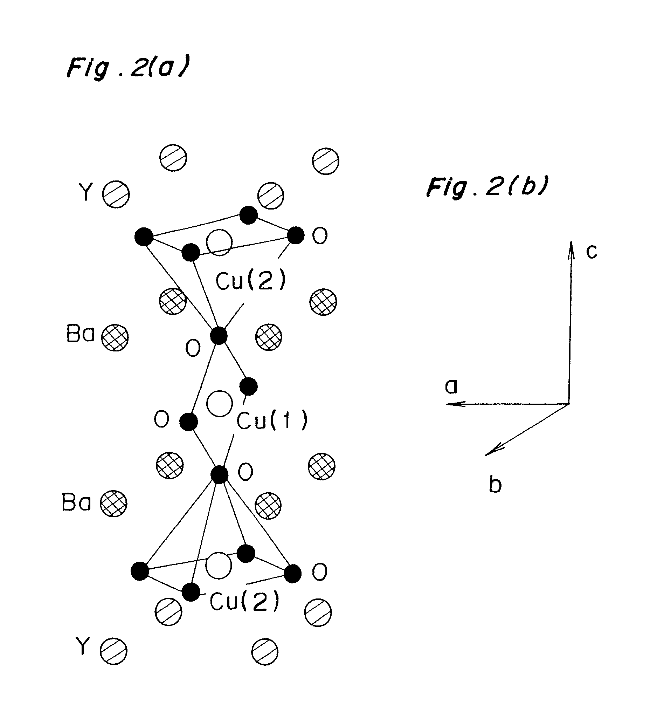

The reason why heat treatment is unnecessary can be explained as follows. As shown in Figures 2(a) and 2(b), an oxide superconductor $YBa_2Cu_3O_y$ has a orthorhombic layered perovskite structure at room temperature. The constituent copper is located in two different sites. Copper atoms Cu(1) form linear Cu-O chains along the b-axis, while the others at Cu(2) form two-dimensional $CuO_2$ planes. It is known that conduction holes in the superconducting state are supplied by oxygen atoms forming Cu-O chains.

In the oxide superconductors of the invention, conduction electrons are supplied by the substitution of elements. That is, an Y-Ba-K-Cu-O system is produced by filling some of what would otherwise be divalent barium sites with monovalent potassium having an ionic radius approximately equal to that of divalent barium ion. By this substitution of element, potassium atoms play the role of supplying the conduction holes. Therefore, prior art heat treatment for increasing the compositional ratio of oxygen becomes unnecessary.

Preferably, the amount of potassium atoms which substitute for barium atoms in the yttrium oxide superconductor according to the invention is between one and ten atom percent.

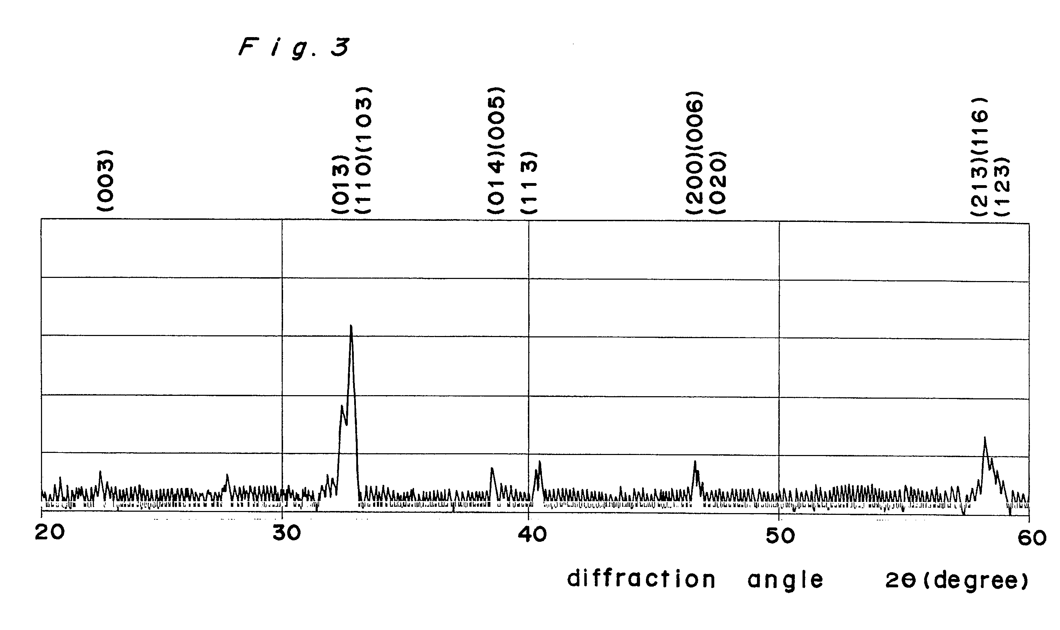

Figure 3 shows a $CuK_\alpha$ X-ray powder diffraction pattern of the oxide superconductor according to the invention. It is observed that the crystal structure is the orthorhombic layered perovskite structure at room temperature, as in prior art Y-Ba-Cu-O system oxide superconductors.

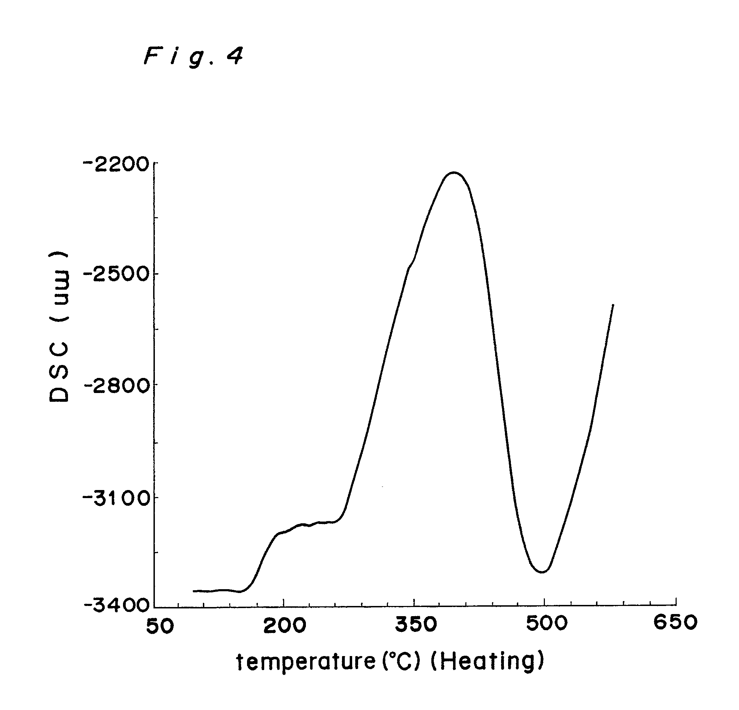

Figure 4 shows the results of thermal analysis by differential scanning calorimetry. It is clear that the oxide superconductor of the invention undergoes a phase transition at around 400°C from the orthorhombic system to a tetragonal system.

## Claims

1. An oxide superconductor having a composition and the crystal structure of $YBa_2Cu_3O_{7-\delta}$, in which barium is partially substituted by potassium.

2. An oxide superconductor according to claim 1, having a composition $YBa_{2(1-x)}K_{2x}Cu_3O_{7-\delta}$, in which $x$ has a value between about 0.01 and about 0.1 and $\delta$ has a value between about one and zero.

3. An oxide superconductor according to claim 2, wherein the value of $x$ is about 0.05.

4. A method for producing an oxide superconductor according to any one of claims 1 to 3, which comprises mixing together $Y_2O_3$, $BaCO_3$, $K_2CO_3$ and $CuO$ in the required proportions, and sintering the mixture.

*Fig. 1*

**Fig . 2(a)**

**Fig . 2(b)**

Fig. 3

diffraction angle 2θ (degree)

(003)

(013)
(110)(103)

(014)(005)
(113)

(200)(006)
(020)

(213)(116)
(123)

EP 0 440 411 A2

*Fig. 4*